# EUROPÄISCHE PATENTANMELDUNG

(11) **EP 1 225 633 A1**
(43) Veröffentlichungstag der Anmeldung: **24.07.2002**
(21) Anmeldenummer: 01101330.7
(22) Anmeldetag: 22.01.2001
(51) Int. Cl.: H01L 23/473

(54) **Heat sink for cooling a power semiconductor device and method of manufacturing such a heat sink**

(71) Anmelder: ABB Schweiz AG, 5400 Baden (CH)
(72) Erfinder: Kaufmann, Stefan, 5000 Aarau (CH); Lang, Thomas, 8050 Zürich (CH)
(74) Vertreter: ABB Patent Attorneys

(57) **Zusammenfassung**

Bei einem Kühler (22) zur Kühlung eines Leistungshalbleiterbauelements bzw. - moduls wird eine einfache Herstellung und eine gute Wärmeabfuhr durch einen porösen Keramikschaumkörper (11) erreicht, welcher über eine Kühlfläche (21) flächig mit dem zu kühlenden Leistungshalbleiterbauelement bzw. -modul in thermischen Kontakt gebracht wird und welcher von einer Kühlflüssigkeit, vorzugsweise Wasser, durchströmt wird.

## Beschreibung

### TECHNISCHES GEBIET

Die vorliegende Erfindung bezieht sich auf das Gebiet der Leistungselektronik. Sie betrifft einen Kühler zur Kühlung eines Leistungshalbleiterbauelements bzw. -moduls sowie ein Verfahren zum Herstellen eines solchen Kühlers.

### STAND DER TECHNIK

Für die Kühlung von Leistungshalbleiterbauelementen (Thyristoren, GTOs, IGBTs etc.) oder mit diesen Bauelementen aufgebauten Modulen mit Sperrspannungen von mehreren kV und Strömen von einigen 100 A werden Kühler bzw. Kühlkörper (Kühldosen) eingesetzt, die von einer Kühlflüssigkeit, häufig Wasser, durchströmt werden. Das heute meist verwendete Material für derartige Kühler bzw. Kühlkörper ist Aluminium, da es sich leicht maschinell bearbeiten lässt, vom Preis her günstig ist und eine hohe Wärmeleitfähigkeit aufweist. Das Problem im Zusammenhang mit Hochleistungshalbleitern ist der hohe Ausdehnungskoeffizient von Aluminium sowie die Tatsache, dass das Kühlwasser den Kühler nur mit einer begrenzten Geschwindigkeit durchfliessen kann, da es sonst zu Erosionserscheinungen kommen kann.

Keramik ist dafür bekannt, dass es kaum Erosion zeigt. Zudem ist der Ausdehnungskoeffizient der gebräuchlichen Keramiken wie Al₂O₃ oder AIN näher am Si als dies bei den Metallen der Fall ist. Nachteilig ist, dass Strukturkeramik nur schwer maschinell bearbeitbar ist und dass daher die Ausbildung von Keramikkühlern mit geeigneten Kanälen für die Kühlmittelströmung mit grossen Schwierigkeiten und erhöhtem Aufwand verbunden ist. So ist in der US-A-5,978,220 der Anmelderin beispielsweise ein Flüssigkeitskühler aus Keramik für ein Hochleistungshalbleitermodul vorgeschlagen worden, bei dem zur Verbesserung der Wärmeübetragung eine Vielzahl von Stiften in der Kühlmittelströmung angeordnet sind. Dieser Aufbau ist vergleichsweise aufwendig.

### DARSTELLUNG DER ERFINDUNG

Es ist daher Aufgabe der Erfindung, einen Kühler aus Keramik zu schaffen, der einfach herzustellen ist und eine gute Wärmeabfuhr vom zu kühlenden Bauelement bzw. Modul ermöglicht, sowie ein Verfahren zum Herstellen eines solchen Kühlers anzugeben.

Die Aufgabe wird durch die Gesamtheit der Merkmale der Ansprüche 1 und 7 gelöst. Die Erfindung geht von der Ueberlegung aus, dass es eine Technologie gibt, mit welcher man einfach keramische Schäume herstellen kann. Dabei wird ein polymerer Schaumstoff mit einem Schlicker getränkt, ausgebrannt und schliesslich gesintert. Der Kern der Erfindung besteht nun darin, einen solchen porösen Keramikschaumkörper über eine Kühlfläche flächig mit dem zu kühlenden Leistungshalbleiterbauelement bzw. -modul in thermischen Kontakt zu bringen und den Keramikschaumkörper von einer Kühlflüssigkeit, vorzugsweise Wasser, durchströmen zu lassen. Durch die Verwendung eines Keramikschaumkörpers entsteht ein Kühler, welcher eine hohe Wärmeleitfähigkeit hat, wegen der Poren eine enge, wirkungsvolle Kühlstruktur aufweist, und keine Erosionserscheinungen zeigt.

Eine bevorzugte Ausgestaltung des Kühlers nach der Erfindung zeichnet sich dadurch aus, dass der Keramikschaumkörper in einem geschlossenen Gehäuse untergebracht ist, dessen Inneres von der Kühlflüssigkeit durchströmt wird, und dass eine Aussenfläche des Gehäuses die Kühlfläche bildet. Hierdurch wird bei kompaktem und einfachem Aufbau eine hohe Kühlwirkung erzielt.

Besonders verschileissfest und wirkungsvoll ist der Kühler, wenn gemäss einer bevorzugten Weiterbildung das Gehäuse aus einer thermisch gut leitenden Keramik hergestellt ist, das Gehäuse aus einem Oberteil und einem Unterteil besteht, Oberteil und Unterteil miteinander durch eine erste Verbindungsschicht, vorzugsweise aus einem Lot oder einer Sinterpaste, stoffschlüssig verbunden sind, und der Keramikschaurnkörper mit dem Oberteil und mit dem Unterteil jeweils durch eine zweite und dritte Verbindungsschicht, vorzugsweise aus einem Lot oder einer Sinterpaste, stoffschlüssig verbunden ist. Insbesondere ist der Keramikschaumkörper aus AIN hergestellt.

Eine bevorzugte Ausgestaltung des erfindungsgemässen Herstellungsverfahrens ist dadurch gekennzeichnet, dass zur stoffschlüssigen Verbindung der Teile Verbindungsschichten aus einem Lot oder einer Sinterpaste verwendet werden.

Weitere Ausführungsformen ergeben sich aus den abhängigen Ansprüchen.

### KURZE ERLÄUTERUNG DER FIGUREN

Die Erfindung soll nachfolgend anhand von Ausführungsbeispielen im Zusammenhang mit der Zeichnung näher erläutert werden. Es zeigen
- Fig. 1: in mehreren Teilfiguren (a) bis (c) verschiedene Schritte zur Herstellung des Keramikschaumkörpers gemäss einem bevorzugten Ausführungsbeispiel des Verfahrens nach der Erfindung; und
- Fig. 2: im Querschnitt eine bevorzugtes Ausführungsbeispiel eines erfindungsgemässen Kühlers.

### WEGE ZUR AUSFÜHRUNG DER ERFINDUNG

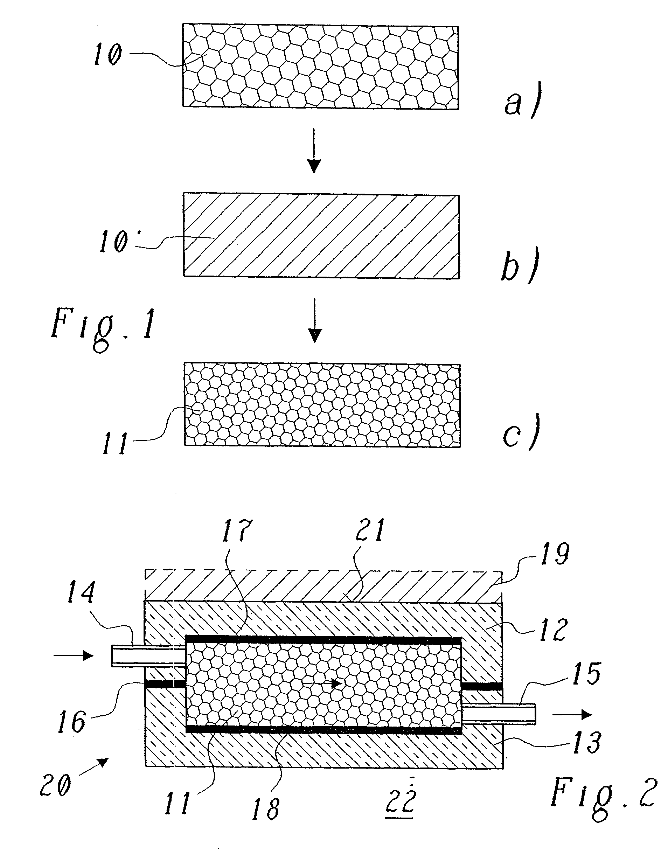

Kern der Erfindung ist der Einsatz eines Keramikschaumkörpers, durch dessen Poren die Kühlflüssigkeit strömt, und der flächig mit dem zu kühlenden Bauelement bzw. Modul in thermischen Kontakt gebracht wird. Ein solcher Keramikschaumkörper 11 kann gemäss Fig. 1 in einer an sich bekannten Weise (siehe z.B. die US-A-5,066,432) hergestellt werden. Ausgangspunkt ist ein Schaumstoffkörper 10 aus einem geeigneten polymeren Schaumstoff (Fig. 1a). Der Schaumstoffkörper 10 liegt dabei in einer dem späteren Keramikschaumkörper im wesentlichen entsprechenden Form (z.B. einer Platte oder kreisrunden Scheibe) vor. Der Schaumstoffkörper 10 wird nun mit einem Schlicker getränkt, der die zur Bildung der Keramik notwendigen Teilchen, vorzugsweise aus AIN, enthält. Es entsteht so ein mit Schlicker getränkter Schaumkörper 10' (Fig. 1b). Der mit Schlicker getränkte Schaumkörper 10' wird dann einer thermischen Behandlung unterzogen, in deren Verlauf der polymere Schaumstoff ausgebrannt und das verbleibende Keramikmaterial zu einem porösen Keramikschaumkörper 11 zusammengesintert wird (Fig. 1c).

Der fertige Keramikschaumkörper 11 wird nun vorzugsweise gemäss Fig. 2 in einem Kühler 22 eingebaut, der ein geschlossenes Gehäuse 20 umfasst, das aus einem (keramischen) Oberteil 12 und einem (keramischen) Unterteil 13 zusammengesetzt ist. Das keramische Material des Gehäuses 20 ist in der thermischen Ausdehnung dem zu kühlenden Bauelement bzw. Modul angepasst und weist eine gute thermische Leitfähigkeit aus. Es ist vorzugsweise dasselbe Material (z.B. AIN), das auch zur Herstellung des Keramikschaumkörpers 11 verwendet wird. Die beiden Teile 12 und 13 des Gehäuses 20 umschliessen einen Innenraum, der in seinen Abmessungen an den Keramikschaumkörper 11 angepasst ist. Zur Montage des Kühlers 22 wird der Keramikschaumkörper 11 in den aus beiden Teilen 12, 13 gebildeten Innenraum eingesetzt und die beiden teile 12, 13 und der Keramikschaumkörper 11 werden untereinander, vorzugsweise in einem Schritt, stoffschlüssig verbunden. Hierzu dienen spezielle Verbindungsschichten 16, 17 und 18, die aus einem Aktivlot oder einer aufgebrachten Sinterpaste gebildet werden. Die Verbindungsschicht 16 verbindet die beiden Teile 12 und 13 und schliesst so das Gehäuse 20 flüssigkeitsdicht. Die beiden Verbindungsschichten 17 und 18 verbinden jeweils die Ober- und Unterseite des Keramikschaumkörpers 11 mit der gegenüberliegenden Innenfläche des Oberteils 12 bzw. Unterteils 13.

Im Kühlbetrieb wird der Keramikschaumkörper 11 quer, d.h. zwischen und parallel zu den Verbindungsschichten 17 und 18, von einer Kühlflüssigkeit, insbesondere Wasser, durchströmt (Pfeil in Fig. 2). Hierzu sind in dem Gehäuse 20 geeignete Anschlussteile 14, 15, z.B. in Form von eingesinterten Röhrchen, vorgesehen, durch welche die Kühlflüssigkeit zu- und wieder abgeführt werden kann. Die parallel zu den Verbinclungsschichten 17, 18 verlaufenden Aussenflächen des Gehäuses 20 dienen bevorzugt als Kühlflächen, die - z.B. durch Presskontakt - in engen thermischen Kontakt mit dem zu kühlenden Bauelement bzw. Modul gebracht werden. Im Beispiel der Fig. 2 steht die obere Kühlfläche 21 in Kontakt mit der (gestrichelt eingezeichneten) Bodenplatte 19 eines Leistungshalbleitermoduls. Die Einleitung der Kühlflüssigkeit in den Keramikschaumkörper 11 und die Ableitung der im Keramikschaumkörper 11 aufgewärmten Kühlflüssigkeit sollte zweckmässigerweise so ausgestaltet sein, dass sich eine möglichst gleichmässige Wärmeabfuhr über die gesamte Oberfläche des Keramikschaumkörpers 11 ergibt. Es ist aber auch denkbar, anstelle eines Keramikschaumkörpers mehrere Keramikschaumkörper vorzusehen, die von der Kühlflüssigkeit umspült und durchströmt werden.

Insgesamt ergibt sich mit der Erfindung ein Kühler, welcher eine hohe Wärmeleitfähigkeit und eine für die Wärmeübertragung optimale enge Kühlstruktur hat, und keine Erosionserscheinungen zeigt.

### BEZUGSZEICHENLISTE

- 10: Schaumstoffkörper
- 10': mit Schlicker getränkter Schaumstoffkörper
- 11: Keramikschaumkörper
- 12: Oberteil (Kühler)
- 13: Unterteil (Kühler)
- 14,15: Anschlussteil (rohrförmig)
- 16,..,18: Verbindungsschicht
- 19: Bodenplatte (Leistungshalbleiterbauelement bzw. -modul)
- 20: Gehäuse
- 21: Kühlfläche
- 22: Kühler

## Patentansprüche

1. Kühler (22) zur Kühlung eines Leistungshalbleiterbauelements bzw. -moduls, **gekennzeichnet durch** einen porösen Keramikschaumkörper (11), welcher über eine Kühlfläche (21) flächig mit dem zu kühlenden Leistungshalbleiterbauelement bzw. -moclul in thermischen Kontakt gebracht wird und welcher von einer Kühlflüssigkeit, vorzugsweise Wasser, durchströmt wird.

2. Kühler nach Anspruch 1, **dadurch gekennzeichnet, dass** der Keramikschaumkörper (11) in einem geschlossenen Gehäuse (20) untergebracht ist, dessen Inneres von der Kühlflüssigkeit durchströmt wird, und dass eine Aussenfläche des Gehäuses (20) die Kühlfläche (21) bildet.

3. Kühler nach Anspruch 2, **dadurch gekennzeichnet, dass** das Gehäuse (20) aus einer thermisch gut leitenden Keramik hergestellt ist, dass das Gehäuse (20) aus einem Oberteil (12) und einem Unterteil (13) besteht, und dass Oberteil (12) und Unterteil (13) miteinander durch eine erste Verbindungsschicht (16), vorzugsweise aus einem Lot oder einer Sinterpaste, stoffschlüssig verbunden sind.

4. Kühler nach Anspruch 3, **dadurch gekennzeichnet, dass** der Keramikschaumkörper (11) mit dem Oberteil (12) und mit dem Unterteil (13) jeweils durch eine zweite und dritte Verbindungsschicht (17 bzw. 18), vorzugsweise aus einem Lot oder einer Sinterpaste, stoffschlüssig verbunden ist.

5. Kühler nach Anspruch 4, **dadurch gekennzeichnet, dass** die zweite und dritte Verbindungsschicht (17 bzw. 18) auf der Ober- bzw. Unterseite des Keramikschaumkörpers (11) angeordnet ist, dass die Kühlfläche (21) parallel zu der zweiten und dritten Verbindungsschicht (17 bzw. 18) verläuft, und dass die Kühlflüssigkeit den Keramikschaumkörper (11) im wesentlichen zwischen und parallel zu den Verbindungsschichten 17, 18) durchströmt.

6. Kühler nach einem der Ansprüche 1 bis 5, **dadurch gekennzeichnet, dass** der Keramikschaurnkörper (11) aus AIN hergestellt ist.

7. Verfahren zum Herstellen eines Kühlers nach einem der Ansprüche 1 bis 6, **dadurch gekennzeichnet, dass** der Keramikschaumkörper (11) in ein aus einem Oberteil (12) und einem Unterteil (13) bestehenden Gehäuse (20) aus Keramik eingesetzt wird, und dass Ober- und Unterteil (12, 13) und der Keramikschaumkörper (11) untereinander stoffschlüssig verbunden werden.

8. Verfahren nach Anspruch 7, **dadurch gekennzeichnet, dass** zur stoffschlüssigen Verbindung der Teile (11, 12, 13) Verbindungsschichten (16, 17, 18) aus einem Lot oder einer Sinterpaste verwendet werden.

9. Verfahren nach Anspruch 7, **dadurch gekennzeichnet, dass** der Keramikschaumkörper (11) durch Tränken eines Schaumstoffkörpers (10) aus einem polymeren Schaumstoff mit einem Keramikschlicker und Ausbrennen und Sintern des getränkten Schaumstoffkörpers (10') hergestellt wird.

10. Verfahren nach Anspruch 9, **dadurch gekennzeichnet, dass** zum Tränken des Schaumstoffkörpers (10) ein Schlicker aus AIN verwendet wird.
